Europäisches Patentamt

European Patent Office

Office européen des brevets

(19)

(11) EP 0 493 832 B1

(12) **FASCICULE DE BREVET EUROPEEN**

(45) Date de publication et mention
de la délivrance du brevet:
**14.02.1996 Bulletin 1996/07**

(51) Int Cl.6: **C03C 14/00**, C04B 35/00,
C04B 35/653

(21) Numéro de dépôt: **91122378.2**

(22) Date de dépôt: **30.12.1991**

(54) **Composite à base d'oxyde supraconducteur à haute température critique et procédé de mise en oeuvre**

Verbundwerkstoff basierend auf supraleitenden Oxiden mit hoher Tc und Verfahren zur Herstellung

Composite based on high Tc-superconducting oxides and its production process

(84) Etats contractants désignés:
**DE FR IT**

(30) Priorité: **04.01.1991 FR 9100072**

(43) Date de publication de la demande:
**08.07.1992 Bulletin 1992/28**

(73) Titulaire:
**ALCATEL ALSTHOM COMPAGNIE GENERALE
D'ELECTRICITE
F-75382 Paris Cédex 08 (FR)**

(72) Inventeurs:
• **Ribes, Michel
F-34830 Clapiers (FR)**
• **Belouet, Christian
F-92330 Sceaux (FR)**

(74) Mandataire: **Weinmiller, Jürgen et al
D-82336 Feldafing (DE)**

(56) Documents cités:
• **MATERIALS RESEARCH BULLETIN, vol. 23, no. 5, mai 1988, pages 623-630, Oxford, GB; C.W. NIES et al.: "Glass-bonded composites containing superconducting YBa2Cu3O9-y for levitation and magnetic shielding applications"**
• **PATENT ABSTRACTS OF JAPAN, vol. 13, no. 388 (C-630)[3736], 28 août 1989**
• **PATENT ABSTRACTS OF JAPAN, vol. 13, no. 326 (C-620)[3674], 24 juillet 1989**
• **JOURNAL OF THE AMERICAN CERAMIC SOCIETY, vol. 73, no. 5, mai 1990, pages 1165-1171, Columbus, Ohio, US; M.R. DE GUIRE et al.: "Superconducting glass-ceramics in the Bi-Sr-Ca-Cu-O system"**
• **NIPPON SERAMIKKUSU KYOKAI GAKUJUTSU RONBUNSHI, vol. 97, no. 2, 1989, pages 251-255, Tokyo, JP; T. KOMATSU et al.: "Preparation and properties of superconducting glass ceramics based on the Bi-Sr-Ca-Cu-O system"**

EP 0 493 832 B1

## Description

La présente invention concerne un procédé de fabrication d'un composite à base d'oxyde supraconducteur à haute température critique.

L'utilisation des oxydes supraconducteurs à haute température critique en électrotechnique suppose, du point de vue de la mise en oeuvre, la réalisation de deux conditions : d'une part une mise en forme appropriée, par exemple en fils ou en rubans, et d'autre part une très forte texturation des cristallites. Cette dernière, caractérisée par un axe $\delta$ commun aux cristallites, est nécessaire pour obtenir les valeurs de densités de courant Jc les plus élevées possibles, y compris sous champ magnétique.

Or, les deux conditions précédentes sont difficiles à satisfaire simultanément par les procédés classiques fondés sur les techniques usuelles de fabrication des céramiques.

Le but de l'invention est de proposer une technique de mise en oeuvre spécifique pour ces matériaux.

Dans l'article paru dans MATERIALS RESEARCH BULLETIN, vol. 23, n° 5, mai 1988, OXFORD GB pages 523-630 ; C.W. NIES et AI : "Glass-bonded composites containing superconducting YBA2CU309-y for levitation and magnetic shielding applications", on décrit des composites comprenant une matrice en verre à faible température de fusion contenant des grains d'YBaCuO.

Ce composite peut être mis en forme de manière plus facile et moins chère que le matériau supraconducteur seul. Ce mélange est comprimé à sec sous 140 MPa, puis déposé à 500°C sur un substrat en alumine.

Les composites obtenus ne permettent pas d'obtenir des valeurs de densités de courant suffisamment élevées.

La présente invention a pour objet un procédé de fabrication d'un composite à base d'oxyde supraconducteur caractérisé par le fait que :

-   l'on réalise un mélange pulvérulent d'un verre dont la température de transition vitreuse Tg est inférieure à 750 K, et d'un oxyde supraconducteur choisi parmi les composés $YBa_2 Cu_3 O_7$, les composés au thallium $Tl_2 Ba_2 Ca_2 Cu_3 O_{10}$ et les composés au bismuth de type $Bi_2 Sr_2 Ca Cu_2 O_x$, $Bi_2 Sr_2 Ca_2 Cu_3 O_y$, le pourcentage en volume de verre étant compris entre 2 % et 40 %
-   l'on effectue une compression uniaxiale dudit mélange à une température comprise entre $T_g$ et $T_x$, $T_x$ étant la température de cristallisation du verre, ladite compression ayant pour effet d'orienter les cristallites dudit oxyde supraconducteur.

Ledit verre est notamment un verre comprenant au moins un oxyde choisi parmi PbO, $B_2O_3$, $Bi_2O_3$, CaO, $SiO_2$ ; dans ce cas la proportion en volume de verre est de préférence inférieure à 20 %.

Ledit verre peut avoir également une formulation proche de celle d'oxydes supraconducteurs vitrifiables du type $Bi_2 Sr_2 Ca Cu_2O_8$ et $Bi_2 Sr_2 Ca_2 Cu_3 O_{10}$, et dans ce cas la proportion en volume de verre peut aller jusqu'à 40 %.

Une phase supplémentaire d'étirage ou de laminage à une température comprise entre $T_g$ et $T_x$ assure la mise en forme du précurseur en fil, ruban, ou bloc.

La nature d'un composite obtenu selon l'invention est telle que l'on peut tirer parti de la malléabilité du verre au-dessus de sa température de transition vitreuse $T_g$, pour la mise en forme et l'orientation des cristallites par pressage uniaxial. Dans le milieu visqueux les cristallites en forme de plaquettes, avec l'axe c normal à la surface principale, s'organisent de façon que leur section prépondérante soit normale à la force de pressage.

Il est avantageux d'utiliser un verre dont la température de transition vitreuse soit inférieure ou égale à 700 K, car cela évite :

-   des réactions de décomposition des oxydes supraconducteurs tels que $YBa_2 Cu_3 O_7$ (perte d'oxygène notamment),
-   des réactions chimiques éventuelles entre le verre et l'oxyde supraconducteur, aboutissant à la dégradation ou à la décomposition de l'oxyde supraconducteur.

Dans le cas particulier où un composite selon l'invention est constitué d'un verre et d'un oxyde dont les formulations cationiques sont identiques ou très voisines, on peut compléter le procédé précédemment défini par un traitement thermique aboutissant à la cristallisation du verre ; on aboutira alors à un matériau homogène, uniquement constitué de supraconducteur si la température de ce traitement thermique est proche de $T_x$, soit environ 700 à 750 K pour les composites au bismuth cités plus haut.

D'autres caractéristiques et avantages de la présente invention apparaîtront au cours de la description suivante d'un mode de réalisation donné à titre illustratif mais nullement limitatif.

On mélange une poudre d'oxyde supraconducteur du type $Bi_{2-x} Pb_x Sr_2 Ca_2 Cu_3O_{10}$ (avec x inférieur à 0,5) et une poudre d'un verre de formulation cationique identique.

Les granulométries sont choisies, pour les supraconducteurs de l'ordre de quelques micromètres à 100 micromètres, et pour le verre de l'ordre du micromètre.

Le pourcentage en volume de verre est de l'ordre de 40 %. Les deux poudres sont finement mélangées selon des procédés classiques et sont ensuite compactées sous air sec en pressage uniaxial à une température Tp égale ou légèrement supérieure à la température T g du verre, mais inférieure à la température de cristallisation $T_x$ du verre.

On exerce dans le moule de pressage une pression de l'ordre de 1 tonne/cm2 et l'on obtient un composite oxyde supraconducteur-verre dont les dimensions géométriques sont fonction de l'utilisation envisagée : bloc, fil ou ruban. C'est en fait un précurseur apte à la mise en forme à une température comprise dans le domaine $T_g$ + 1/3 ($T_x$ - $T_g$) et $T_g$ + 2/3 ($T_x$ - $T_g$), par exemple par extrusion (pour un fil) ou par laminage (pour un ruban).

Compte tenu des formulations choisies pour les deux poudres initiales, un traitement thermique supplémentaire à une température voisine de $T_x$ permet de convertir l'ensemble du verre en matériau supraconducteur si cela est nécessaire.

Bien entendu l'invention n'est pas limitée au mode de réalisation qui vient d'être décrit.

## Revendications

1. Procédé de fabrication d'un composite à base d'oxyde supraconducteur caractérisé par le fait que :

    - l'on réalise un mélange pulvérulent d'un verre dont la température de transition vitreuse $T_g$ est inférieure à 750K, et d'un oxyde supraconducteur choisi parmi les composés $YBa_2\,Cu_3\,O_7$, les composés au thallium $Tl_2\,Ba_2\,Ca_2\,Cu_3\,O_{10}$ et les composés au bismuth de type $Bi_2\,Sr_2\,Ca\,Cu_2\,O_x$, $Bi_2\,Sr_2\,Ca_2\,Cu_3\,O_y$, le pourcentage en volume de verre étant compris entre 2 % et 40 %

    - l'on effectue une compression uniaxiale dudit mélange à une température comprise entre $T_g$ et $T_X$, $T_X$ étant la température de cristallisation du verre, ladite compression ayant pour effet d'orienter les cristallites dudit oxyde supraconducteur.

2. Procédé de fabrication selon la revendication 1, caractérisé par le fait que ledit verre est un verre comprenant un oxyde choisi parmi PbO, $B_2O_3$, $Bi_2O_3$, CaO, $SiO_2$, la proportion en volume de verre étant alors inférieure à 20 %.

3. Procédé de fabrication selon la revendication 1, caractérisé par le fait que ledit verre a une formulation proche de celle d'oxydes supraconducteurs vitrifiables du type $Bi_2\,Sr_2\,Ca\,Cu_2\,O_8$ et $Bi_2\,Sr_2\,Ca_2\,Cu_3\,O_{10}$.

4. Procédé de fabrication selon la revendication 1, caractérisé par le fait que ledit composite subit une phase supplémentaire d'étirage ou de laminage à une température comprise entre $T_g$ et $T_X$ assurant la mise en forme de ce composite.

5. Procédé de fabrication selon la revendication 3, caractérisé par le fait que ledit composite subit une phase supplémentaire d'étirage ou de laminage assurant la mise en forme de ce composite à une température comprise entre $T_g$ + 1/3 ($T_x$ - $T_g$) et $T_g$ + 2/3 ($T_x$ - $T_g$).

6. Procédé de fabrication selon la revendication 5, caractérisé par le fait que ledit composite subit enfin un traitement thermique à une température proche de $T_x$, de l'ordre de 700 K à 750 K, pour cristalliser ledit verre.

## Patentansprüche

1. Herstellungsverfahren für einen Verbundwerkstoff auf der Basis von supraleitenden Oxiden, dadurch gekennzeichnet, daß

    - eine Mischung aus einem Glaspulver, dessen Temperatur des Übergangs in den glasartigen Zustand $T_g$ unter 750 K liegt, und einem Pulver eines supraleitenden Oxid hergestellt wird, das aus den Verbindungen $YBa_2Cu_3O_7$, den Thalliumverbindungen $Tl_2Ba_2Ca_2Cu_3O_{10}$ und den Wismuthverbindungen $Bi_2Sr_2CaCu_2O_x$, $Bl_2Sr_2Ca_2Cu_3O_y$ ausgewählt wird, wobei der Glasanteil am Gesamtvolumen zwischen 2 und 40% liegt,

    - eine uniaxiale Komprimierung dieser Mischung bei einer Temperatur zwischen $T_g$ und $T_x$ durchgeführt wird, wobei $T_x$ die Kristallisationstemperatur des Glases ist und wobei die Komprimierung zur Wirkung hat, die Kristallite des supraleitenden Oxids auszurichten.

2. Herstellungsverfahren nach Anspruch 1, dadurch gekennzeichnet, daß das Glas ein Oxid aufweist, das aus PbO, $B_2O_3$, $Bi_2O_3$, CaO, $SiO_2$ ausgewählt wird, wobei der Anteil des Glases am Gesamtvolumen vorzugsweise weniger als 20% beträgt.

3. Herstellungsverfahren nach Anspruch 1, dadurch gekennzeichnet, daß das Glas eine Formulierung nahe der der verglasbaren supraleitenden Oxide der Art $Bi_2Sr_2CaCu_2O_8$ und $Bi_2Sr_2Ca_2Cu_3O_{10}$ hat.

4. Herstellungsverfahren nach Anspruch 1, dadurch gekennzeichnet, daß der Verbundwerkstoff einer zusätzliche Ziehoder Walzphase bei einer Temperatur zwischen $T_g$ und $T_x$ unterzogen wird, die dem Verbundwerkstoff die endgültige Form verleiht.

5. Herstellungsverfahren nach Anspruch 3, dadurch gekennzeichnet, daß der Verbundwerkstoff einer zusätzlichen Ziehoder Walzphase unterzogen wird, die diesem Verbundwerkstoff bei einer Temperatur zwischen $T_g$ + 1/3($T_x$ - $T_g$) und $T_g$ + 2/3($T_x$ - $T_g$) die endgültige Form verleiht.

6. Herstellungsverfahren nach Anspruch 5, dadurch gekennzeichnet, daß der Verbundwerkstoff schließlich einer Wärmebehandlung bei einer Temperatur nahe $T_x$ von etwa 700 bis 750 K unterzogen wird, um das Glas zu kristallisieren.

## Claims

1. A method of manufacturing a composite based on a superconducting oxide, characterized by the fact that:

   a powder mixture is made of a superconducting oxide selected from compounds of $YBa_2Cu_3O_7$, compounds of thallium $Tl_2Ba_2Ca_2Cu_3O_{10}$, and compounds of bismuth of the $Bi_2Sr_2CaCu_2O_x$ and $Bi_2Sr_2Ca_2Cu_3O_y$ types, and a glass whose vitreous transition temperature $T_g$ is less than 750 K, with the volume percentage of the glass lying in the range 2% to 40%; and said mixture is compressed uniaxially at a temperature lying in the range $T_g$ to $T_x$, where $T_x$ is the crystallization temperature of the glass, said compression having the effect of orienting the crystallites of said superconducting oxide.

2. A method of manufacture according to claim 1, characterized by the fact that said glass is a glass comprising an oxide selected from PbO, $B_2O_3$, $Bi_2O_3$, CaO, $SiO_2$, with the volume fraction of the glass then being less than 20%.

3. A method of manufacture according to claim 1, characterized by the fact that said glass has a formulation close to that of vitrifiable superconducting oxides of the $Bi_2Sr_2CaCu_2O_8$ or $Bi_2Sr_2Ca_2Cu_3O_{10}$ types.

4. A method of manufacture according to claim 1, characterized by the fact that said composite is subjected to an additional step of drawing or rolling at a temperature lying in the range $T_g$ to $T_x$, thereby forming said composite.

5. A method of manufacture according to claim 3, characterized by the fact that said composite is subjected to an additional step of drawing or rolling, thereby forming the composite at a temperature lying in the range $T_g + (1/3)(T_x - T_g)$ to $T_g + (2/3)(T_x - T_g)$.

6. A method of manufacture according to claim 5, characterized by the fact that said composite is finally subjected to a heat treatment at a temperature close to $T_x$, of the order of 700 K to 750 K, for crystallizing said glass.